# EUROPÄISCHE PATENTANMELDUNG

(11) **EP 4 624 955 A1**
(43) Veröffentlichungstag der Anmeldung: **01.10.2025**
(21) Anmeldenummer: 24167202.1
(22) Anmeldetag: 28.03.2024
(51) Int. Cl.: G01R 31/374, G01R 31/3832, G01R 31/385, G01R 31/392

(54) **VERFAHREN ZUM BESTIMMEN EINER EINE BATTERIEZELLE CHARAKTERISIERENDEN EIGENSCHAFT MITTELS EINER MESSVORRICHTUNG, COMPUTERPROGRAMMPRODUKT, COMPUTERLESBARES SPEICHERMEDIUM SOWIE MESSVORRICHTUNG**

(71) Anmelder: Siemens Aktiengesellschaft, 80333 München (DE)
(72) Erfinder: Radinger, Hannes, 90459 Nürnberg (DE); Arzberger, Arno, 96135 Stegaurach (DE); Fischer, Michael, 91320 Ebermannstadt (DE); Katzer, Felix, 90763 Fürth (DE)
(74) Vertreter: Siemens Patent Attorneys

(57) **Zusammenfassung**

Die Erfindung betrifft ein Verfahren zum Bestimmen einer eine Batteriezelle (12) charakterisierenden Eigenschaft mittels einer Messvorrichtung (10), mit den Schritten: Bereitstellen eines Soll-Stromwertes für einen Ladevorgang der Batteriezelle (12) mittels einer elektronischen Recheneinrichtung (14) der Messvorrichtung (10); Einstellen eines Ladestromwertes zum Laden der Batteriezelle (12) an einem Zyklisierer (16) der Messvorrichtung (10) in Abhängigkeit von dem Soll-Stromwert mittels des Zyklisierers (16); Bestimmen einer Temperatur des Zyklisierers (16) während des Ladevorgangs mittels einer Temperaturerfassungseinrichtung (18) der Messvorrichtung (10); Anpassen des Ladestromwertes während des Ladevorgangs in Abhängigkeit von der bestimmten Temperatur zum Erreichen des Soll-Stromwertes mittels des Zyklisierers(16); Laden der Batteriezelle (12) mittels des angepassten Ladestromwertes mittels des Zyklisierers (16); und Bestimmen der die Batteriezelle (12) charakterisierenden Eigenschaft auf Basis des durchgeführten Ladevorgangs mittels der elektronischen Recheneinrichtung (14). erner betrifft die Erfindung ein Computerprogrammprodukt, ein computerlesbares Speichermedium sowie eine Messvorrichtung (10).

## Beschreibung

Die Erfindung betrifft ein Verfahren zum Bestimmen einer eine Batteriezelle charakterisierenden Eigenschaft mittels einer Messvorrichtung gemäß dem geltenden Patentanspruch 1. Ferner betrifft die Erfindung ein Computerprogrammprodukt, ein computerlesbares Speichermedium sowie eine Messvorrichtung.

Für die Bestimmung einer Qualität einer Batteriezelle am Ende der Produktion finden sogenannte "End of Line"-Tests statt, bei denen charakterisierende Kenngrößen bestimmt werden. Über die prognostizierte Lebensdauer kann beispielsweise der Verlust an nutzbarer Kapazität der Batteriezelle in Abhängigkeit von der Zyklenzahl bestimmt werden. Die Selbstentladungsrate beschreibt den Verlust an Kapazität durch Zell-interne Reaktionen, sodass diese Energie nicht nutzbar gemacht werden kann.

Beide Kenngrößen werden in der Regel über eine mehrtägige Messung bestimmt, die enormen Platz in der Produktionsstätte und viel Zeit für den Zellhersteller beansprucht. Es ist daher notwendig, neue Methoden zu entwickeln, um dieselben Kenngrößen zu bestimmen, dabei allerdings die Messzeit signifikant zu reduzieren, um Zeit, Energie und Kosten zu sparen.

Im Stand der Technik wird auf beschleunigte Tests zurückgegriffen, die bei höheren Temperaturen und gegebenenfalls höheren Stromstärken durchgeführt werden und so eine beschleunigte Alterung und Selbstentladung der Batteriezellen verursachen. Diese künstlich herbeigeführten Bedingungen stellen allerdings nicht das Verhalten der Batteriezellen unter relevanten Betriebsbedingungen dar, welches eigentlich durch diese Tests beschrieben werden soll.

Ein bereits aus dem Stand der Technik bekanntes Verfahren hat eine erhöhte Genauigkeit der Messung als Grundlage, mit der kleinste Änderungen auf kurzen Zeitskalen quantifiziert werden können. Ein Beispiel dafür ist die sogenannte High Precision Coulometry (HPC), bei der die aus der Batteriezelle entnommene beziehungsweise ihr zugeführte Ladungsmenge präzise gezählt wird. Das Messprinzip basiert auf einer Zyklisierung der Batteriezelle zwischen zwei definierten Arbeitspunkten, die durch Ladungszustand (State of Charge - SoC) bestimmt werden. Mittels des HPC-Verfahrens werden die exakten Ladungsmengen gemessen und daraus die sogenannte Coulomb-Effizienz (CE) berechnet. Dadurch können selbst geringe Kapazitätsverluste innerhalb weniger Zyklen bestimmt und das Langzeitverhalten der Batteriezelle prognostiziert werden.

In diesem hochpräzisen Bereich müssen Messfehler möglichst ausgeschlossen werden. Messfehler können allerdings nur dann vermieden werden, wenn die Umgebungsbedingungen, in denen die Messungen stattfinden, sowie die Instrumente, mit denen die Analysen durchgeführt werden, konstante Bedingungen aufweisen. Einer der Hauptparameter, der die Messgenauigkeit eines Potentiostat beziehungsweise Zyklisierers bestimmt, ist die Temperatur seines internen elektrischen Schaltkreises. Temperaturschwankungen der Elektronik führen zu Veränderungen innerer Widerstände und veränderten Kapazitäten von Kondensatoren.

Hierbei ist aus dem Stand der Technik bereits bekannt, dass, um den Temperaturschwankungen des Potentiostaten zumindest ansatzweise entgegenzutreten, ein Wärmemanagement durchgeführt wird. Die Hersteller verwenden dabei Wärmemanagementtechniken wie Kühlkörper, Lüfter und Flüssigkeitskühlsysteme, um die von den elektronischen Komponenten erzeugte Wärme abzuführen. Diese Techniken tragen dazu bei, die Temperatur der Komponenten innerhalb eines bestimmten Bereichs zu halten und Temperaturschwankungen zu reduzieren. Ferner sind Temperaturregelkreise bekannt, um die Temperatur der elektronischen Komponenten in Echtzeit anzupassen. Diese Schaltkreise können das Kühlsystem auf der Grundlage von Temperatursensordaten beispielsweise anpassen und eine konstante Temperatur aufrechterhalten. Ferner können auch temperaturgeregelte Gehäuse für den Potentiostaten verwendet werden. Dies kann dazu beitragen, eine konstante Temperatur in der Umgebung aufrecht zu erhalten, was die Auswirkungen von Temperaturschwankungen auf das Gerät verringert.

Aufgabe der vorliegenden Erfindung ist es, ein Verfahren, ein Computerprogrammprodukt, ein computerlesbares Speichermedium sowie eine Messvorrichtung zu schaffen, mittels welchen auf einfache Art und Weise eine genaue Messung einer charakterisierenden Eigenschaft einer Batteriezelle realisiert werden kann.

Diese Aufgabe wird durch ein Verfahren, ein Computerprogrammprodukt, ein computerlesbares Speichermedium sowie eine Messvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen einer eine Batteriezelle charakterisierenden Eigenschaft mittels einer Messvorrichtung. Es wird ein Soll-Stromwert für einen Ladevorgang der Batteriezelle mittels einer elektronischen Recheneinrichtung der Messvorrichtung bereitgestellt. Es erfolgt das Einstellen eines Ladestromwertes zum Laden der Batteriezelle an dem Zyklisierer der Messvorrichtung in Abhängigkeit von dem Soll-Stromwert mittels des Zyklisierers. Es wird eine Temperatur des Zyklisierers während des Ladevorgangs mittels einer Temperaturerfassung der Messvorrichtung bestimmt. Der Ladestromwert wird während des Ladevorgangs in Abhängigkeit von der bestimmten Temperatur zum Erreichen des Soll-Stromwertes mittels des Zyklisierers angepasst. Es erfolgt dann das Laden der Batteriezelle mittels des angepassten Ladestromwerts mittels des Zyklisierers und das Bestimmen der die Batteriezelle charakterisierenden Eigenschaft auf Basis des durchgeführten Ladevorgangs mittels der elektronischen Recheneinrichtung.

Insbesondere löst somit die Erfindung das Problem, dass anstatt komplexe und teure Elemente, wie im Stand der Technik, in den Zyklisierer integriert werden, um den Abfluss von Wärme zu verbessern oder die Temperatur zu regulieren, wird hier akzeptiert, dass die Temperaturen über den zeitlichen Verlauf nicht konstant sind. Um die Schwankungen durch die Temperatur auszugleichen, wird in einem erweiterten Schaltkreis insbesondere ein sogenanntes Kalibriergerät zwischengeschaltet, damit in regelmäßigen Abständen schnell und effizient beispielsweise ein Korrekturfaktor ermittelt werden kann, mit dessen Hilfe eine exakte Strommessung durchgeführt wird.

Der erweiterte Schaltkreis, insbesondere die Temperaturerfassungseinrichtung, weist dabei einen Temperatursensor auf, der die Temperatur der elektronischen Komponenten misst. Der Temperatursensor kann ein Thermoelement, ein Thermistor oder eine andere Art von temperaturempfindlichem Gerät sein. Er umfasst auch einen sogenannten Controller, der die Daten des Temperatursensors verarbeitet und bestimmt, wann eine erneute Kalibrierung durchzuführen ist. Bei dem Steuergerät beziehungsweise der elektronischen Recheneinrichtung kann es sich um einen Mikrocontroller oder ein anderes elektronisches Gerät handeln, das für die Ausführung von Temperatursteuerungsfunktionen programmiert ist.

Weicht die Temperatur von einem vorprogrammierten Wert ab, stoppt beispielsweise der Mikrocontroller die HPC-Messung an einem der definierten Arbeitspunkte (SoC). Währenddessen schaltet der Controller auf das Kalibriergerät um und die Messung der Stromstärke wird neu eingestellt - unter Berücksichtigung der aktuellen Umgebungsbedingungen inklusive der Temperatur der Bauteile. Die jeweils gemessenen Stromwerte während der Kalibration innerhalb des Zyklisierers, welcher auch als Potentiostat bezeichnet wird, sowie im externen Kalibriergerät werden miteinander ab- und ausgeglichen.

Mit anderen Worten erfolgt die Integration eines erweiterten Schaltkreises zur Steuerung der Strommessung, indem die Temperatur konstant ermittelt wird und bei Überschreiten eines definierten Deltas beispielsweise über einen Mikrocontroller den Stromkreis über ein Kalibriergerät öffnet. Die regelmäßige und präzise Bestimmung der Temperatur der elektronischen Bauteile des Potentiostaten, abhängig von der Messzeit und den Umgebungsbedingungen, wie zum Beispiel Temperatur, ist dabei vorteilhaft für ein HPC-Verfahren. Dadurch kann ein Korrekturfaktor ermittelt werden, mit dem die Strommessgenauigkeit des Zyklisierers signifikant erhöht wird.

Dadurch ist eine HPC-Messung unabhängig von Schwankungen der Temperatur der elektrischen Bauteile innerhalb des Potentiostaten ermöglicht.

Im Gegensatz zum Stand der Technik ergeben sich dabei mehrere Vorteile. Zum einen können Temperaturschwankungen nicht nur reduziert, sondern genau ermittelt und innerhalb der Messung korrigiert werden. Des Weiteren können Zeit und Kosten eingespart werden, da der Potentiostat nicht mehr in teuren Wärmeableitern oder Thermoelementen ausgestattet werden muss. Des Weiteren wird die Strommessgenauigkeit erhöht, da in regelmäßigen Abständen die Messvorrichtung unkompliziert und schnell kalibriert wird, um die aktuellen Arbeitspunkte exakt zu parametrieren.

Die hier offenbarten und auch weiteren Schritte beim Ladevorgang gelten analog auch für den Entladevorgang.

Gemäß einer vorteilhaften Ausgestaltungsform wird nach dem Ladevorgang ein Entladevorgang durchgeführt und während des Entladevorgangs eine Temperaturmessung und eine Anpassung eines Entladestromwerts während des Entladens durchgeführt. Insbesondere wird somit analog zum Ladevorgang auch der Entladevorgang durchgeführt. Mit anderen Worten kann ein Soll-Stromwert für das Entladen vorgegeben werden und in Abhängigkeit von der Temperatur dann eine Anpassung des Entladestromwerts durchgeführt werden. Somit kann beispielsweise das Verfahren hochgenau bei einem sogenannten HPC-Verfahren eingesetzt werden und während der entsprechenden Ladezyklen und Entladezyklen hochpräzise das Messverfahren durchgeführt werden.

Weiterhin vorteilhaft ist, wenn der Ladestromwert kontinuierlich während des Ladevorgangs angepasst wird. Insbesondere ist unter kontinuierlich zu verstehen, dass während des Ladevorgangs nicht nur einmal eine Anpassung des Ladestromwerts durchgeführt wird, sondern insbesondere mehrfach. Somit kann hochpräzise die charakterisierende Eigenschaft bestimmt werden.

Es hat sich weiterhin als vorteilhaft erwiesen, wenn während des Anpassens des Ladestromwerts der Ladevorgang unterbrochen wird. Mit anderen Worten kann kurzfristig der Ladevorgang unterbrochen werden, um den Ladestromwert entsprechend anzupassen. Somit kann präzise die charakterisierende Eigenschaft der Batteriezelle bestimmt werden.

Dabei kann weiterhin vorgesehen sein, dass zum Unterbrechen eine Schalteinrichtung des Zyklisierers zur Batteriezelle geöffnet wird. Hierbei ist insbesondere vorgesehen, dass dann erst im geöffneten Zustand der Schalteinrichtung die Anpassung des Ladestromwerts durchgeführt wird. Nachdem der Ladestromwert dann wiederum angepasst ist, erfolgt wiederum ein Schließen der Schalteinrichtung und der Ladevorgang wird erneut fortgeführt.

In einer weiteren vorteilhaften Ausgestaltungsform ist vorgesehen, dass die Schalteinrichtung als Halbleiterelement bereitgestellt wird. Insbesondere kann die Schalteinrichtung beispielsweise als MOSFET ausgebildet sein. Alternativ kann die Schalteinrichtung auch als elektronischer Schalter beziehungsweise als mechanischer Schalter ausgebildet sein. Somit kann auf einfache Bauteile zurückgegriffen werden und vorteilhaft das Verfahren auf einfache Art und Weise durchgeführt werden.

Ferner hat es sich als vorteilhaft erwiesen, wenn auf Basis einer zugeführten Ladungsmenge während des Ladevorgangs und auf Basis einer entnommenen Ladungsmenge während eines Entladevorgangs der Batteriezelle mittels des Zyklisierers die charakterisierende Eigenschaft bestimmt wird. Vorteilhafterweise werden mehrere Zyklen von Ladungen und Entladungen durchgeführt. Insbesondere hat dies den Vorteil, dass auf Basis der Ladungsmengen zuverlässig die entsprechende charakterisierende Eigenschaft bestimmt werden kann. Beispielsweise kann auf Basis des HPC-Verfahrens die charakterisierende Eigenschaft bestimmt werden.

Es hat sich weiterhin als vorteilhaft erwiesen, wenn als charakterisierende Eigenschaft eine Lebensdauer der Batteriezelle und/oder eine Selbstentladungsrate der Batteriezelle bestimmt werden. Insbesondere Batteriezellen weisen die so genannte Selbstentladungsrate auf, welche dazu führt, dass ohne äußeren Einfluss dennoch eine Entladung der Batteriezelle aufzufinden ist. Diese Selbstentladungsrate ist wiederum eine spezifische charakterisierende Eigenschaft einer spezifischen Batteriezelle. Diese dient insbesondere zur Qualitätsbestimmung der Batteriezelle. Es ist nun möglich, dass die Selbstentladungsrate zuverlässig und hochpräzise auf Basis des vorgestellten Verfahrens bestimmt werden kann. Insbesondere die Lebensdauer der Batteriezelle ist ebenfalls eine wichtige Kenngröße einer spezifischen Batteriezelle und dient insbesondere zum Bestimmen der Qualität der Batteriezelle. Dabei kann zusätzlich oder ergänzend als die charakterisierende Eigenschaft ein Kapazitätsverlust pro Zyklus der Batteriezelle bestimmt werden. Auf Basis des Kapazitätsverlusts können beispielsweise die Lebensdauer und/oder die Selbstentladungsrate bestimmt werden. Die Bestimmung des Kapazitätsverlusts benötigt noch mindestens eine weitere Ladungsmenge eines folgenden Zyklus. Somit werden mehrere Qcharge (zugeführte Ladungsmenge) und Qdischarge (entnommene Ladungsmenge) aus mehreren Zyklen benötigt, da hier beispielsweise der Unterschied von Qdischarge aus zwei aufeinanderfolgenden Zyklen verglichen wird. Somit kann mittels des vorgeschlagenen Verfahrens die Lebensdauer der Batteriezelle bestimmt werden.

Weiterhin vorteilhaft ist, wenn das Verfahren während eines Hochpräzisionscoulometrie-Verfahrens durchgeführt wird. Dabei handelt es sich insbesondere um das bereits erwähnte High Precision Coulometry (HPC)-Verfahren. Das HPC-Verfahren misst die genauen Ladungsmengen während der einzelnen Lade- und Entladeschritte. Insbesondere verfolgt dabei das HPC-Verfahren entsprechende Testzyklen, bei denen die Batteriezelle zwischen zwei definierten Zuständen, insbesondere beschrieben durch eine Maximalspannung und eine Minimalspannung mit einer definierten Stromstärke zyklisiert wird. Die Dauer der einzelnen Lade- und Entladeschritte tcharge und tdischarge hängen dabei von den Eigenschaften der getesteten Batteriezelle ab. Auf Basis des HPC-Verfahrens kann somit hochpräzise die Coulombic Effeciency entsprechend bestimmt werden und auf Basis dessen wiederum zuverlässig die charakterisierende Eingabe der Batteriezelle bestimmt werden.

In einer weiteren vorteilhaften Ausgestaltungsform ist vorgesehen, dass zumindest nach dem Ladevorgang eine weitere Temperaturmessung durchgeführt wird. Sollte beispielsweise während des Ladevorgangs ein entsprechender Schwellwert bei der Temperaturänderung nicht verzeichnet worden sein, so kann zumindest nach dem Ladevorgang eine weitere Temperaturmessung durchgeführt werden und nach dem Ladevorgang, bei welchem insbesondere eine Unterbrechung zum Entladevorgang kurzfristig durchgeführt wird, eine entsprechenden Anpassung des Ladestromwerts durchgeführt werden. Somit kann hochpräzise das Verfahren zum Durchführen beziehungsweise Bestimmen der charakterisierenden Eigenschaft bereitgestellt werden.

Weiterhin vorteilhaft ist, wenn bei einem Überschreiten von zumindest einem Temperaturschwellwert eine Anpassung des Ladestromwerts durchgeführt wird. Insbesondere kann somit inkrementell eine Vielzahl von Temperaturschwellwerten bereitgestellt werden. Jedes Mal, wenn ein Temperaturschwellwert überschritten wird, erfolgt dann eine kurzfristige Unterbrechung des Ladevorgangs und eine Anpassung des Ladestromwerts. Somit kann hocheffizient das Verfahren durchgeführt werden.

Ebenfalls vorteilhaft ist, wenn zum Anpassen des Ladestromwerts ein Korrekturfaktor in Abhängigkeit von dem Soll-Stromwert und der Temperatur ermittelt wird. Insbesondere werden somit die Schwankungen durch die Temperatur ausgeglichen, wobei insbesondere dann wiederum im erweiterten Schaltkreis, insbesondere der Temperaturerfassungseinrichtung, beispielsweise das Kalibriergerät mit zwischengeschaltet ist, damit in regelmäßigen Abständen schnell und effizient der Korrekturfaktor ermittelt werden kann, mit dessen Hilfe eine exakte Strommessung durchgeführt werden kann.

Bei dem vorgestellten Verfahren handelt es sich insbesondere im Wesentlichen um ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen.

Ebenfalls betrifft die Erfindung auch ein computerlesbares Speichermedium mit dem Computerprogrammprodukt nach dem vorhergehenden Aspekt.

Weiterhin betrifft die Erfindung auch eine Messvorrichtung zum Bestimmen einer eine Batteriezelle charakterisierenden Eigenschaft, mit zumindest einem Zyklisierer, einer elektronischen Recheneinrichtung und einer Temperaturerfassungseinrichtung, wobei die Messvorrichtung zum Durchführen eines Verfahrens nach dem vorhergehenden Aspekt ausgebildet ist. Insbesondere wird das Verfahren mittels der Messvorrichtung durchgeführt.

Vorteilhafte Ausgestaltungsformen des Verfahrens sind als vorteilhafte Ausgestaltungsformen des Computerprogrammprodukts, des computerlesbaren Speichermediums sowie der Messvorrichtung anzusehen. Die Messvorrichtung weist hierzu insbesondere gegenständliche Merkmale auf, um entsprechende Verfahrensschritte durchführen zu können.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei einem erfindungsgemäßen Verfahren ergeben können und die hierin nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- FIG 1: ein schematisches Blockschaltbild gemäß einer Ausführungsform einer Messvorrichtung; und
- FIG 2: ein weiteres schematisches Blockschaltbild einer Ausführungsform der Messvorrichtung.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

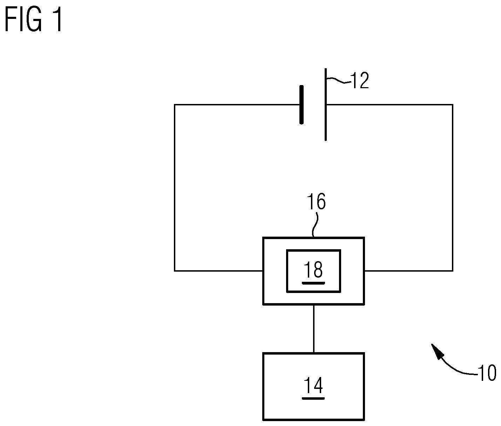

FIG 1 zeigt ein schematisches Blockschaltbild gemäß einer Ausführungsform einer Messvorrichtung 10. Die Messvorrichtung 10 ist insbesondere zum Bestimmen einer charakterisierenden Eigenschaft einer Batteriezelle 12 ausgebildet. Hierzu weist die Messvorrichtung 10 zumindest eine elektronische Recheneinrichtung 14 sowie einen Zyklisierer 16 auf. Des Weiteren zeigt die FIG 1, dass die Messvorrichtung 10 eine Temperaturerfassungseinrichtung 18 aufweist.

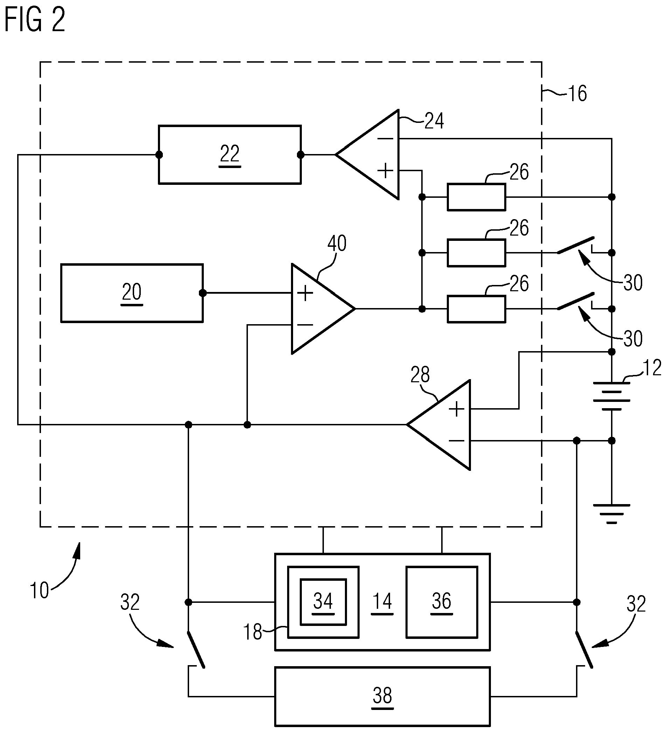

FIG 2 zeigt ein weiteres schematisches Blockschaltbild gemäß einer Ausführungsform der Messvorrichtung 10. Insbesondere ist der Zyklisierer 16 detaillierter dargestellt. Der Zyklisierer 16 weist einen Signalgenerator 20 auf. Der Signalgenerator 20 bestimmt die Auflösung der Spannung des Zyklisierers 16. Er gibt mittels einer Konvertierung, insbesondere auf Basis eines Signalkonvertierers 22 eines computergenerierten Signals DC-Spannungen aus. An dem Stromverstärker 24 wird der Strom gemessen, der durch die Batteriezelle 12 fließt. Mehrere Widerstände 26 mit unterschiedlichen Werten sind dazu da, um den jeweiligen Strombereich bestmöglich aufzulösen. Fließt der Strom über einen der Widerstände 26, fällt eine Spannung ab, die durch den Verstärker verstärkt wird und im Signalkonvertierer 22 wieder in eine Strommessung rückgeführt wird. Hierzu ist insbesondere ein Feedbackverstärker 28 vorgesehen. Des Weiteren ist ein Kontrollverstärker 40 gezeigt.

Wenn sich der Potentiostat beziehungsweise Zyklisierer 16 erwärmt, kann dies die Genauigkeit der Strommessung beeinträchtigen, insbesondere kann der Widerstand der elektronischen Bauteile aufgrund des Temperaturkoeffizienten des Widerstands mit steigender Temperatur zunehmen. Dies kann dazu führen, dass der Spannungsabfall an den Bauteilen zunimmt, was die Genauigkeit der Spannungsmessungen und die Gesamtgenauigkeit der Strommessungen beeinträchtigt.

Darüber hinaus können Temperaturschwankungen auch die Stabilität des Zyklisierers 16 im Laufe der Zeit beeinträchtigen. Wenn sich die Temperatur der elektronischen Komponenten ändert, ist das Verhalten der Komponenten weniger vorhersehbar, was zu Schwankungen bei den Messwerten führt. Dies erschwert es, genaue und wiederholbare Messungen zu erzielen, insbesondere über längere Zeiträume oder bei Experimenten mit komplexeren oder dynamischen Bedingungen, wie beispielsweise dem HPC-Verfahren (High Precision Coulometry).

Erfindungsgemäß ist hierbei ein Verfahren vorgesehen, um präzise eine charakterisierende Eigenschaft der Batteriezelle 12 zu bestimmen. Es wird ein Soll-Stromwert für einen Ladevorgang der Batteriezelle 12 mittels der elektronischen Recheneinrichtung 14 vorgegeben. Es erfolgt das Einstellen eines Ladestromwerts zum Laden der Batteriezelle 12 an dem Zyklisierer 16 der Messvorrichtung 10 in Abhängigkeit von dem Soll-Stromwert mittels des Zyklisierers 16. Es wird die Temperatur des Zyklisierers 16 während des Ladevorgangs mittels der Temperaturerfassungseinrichtung 18 bestimmt. Es erfolgt das Anpassen des Ladestromwerts während des Ladevorgangs in Abhängigkeit von der bestimmten Temperatur zum Erreichen des Soll-Stromwerts mittels des Zyklisierers 16, insbesondere auf Basis einer Signalerzeugung durch die elektronische Recheneinrichtung 14. Es wird dann die Batteriezelle 12 mittels des angepassten Ladestromwerts mittels des Zyklisierers 16 geladen und es erfolgt das Bestimmen der die Batteriezelle 12 charakterisierenden Eigenschaft auf Basis des durchgeführten Ladevorgangs mittels der elektronischen Recheneinrichtung 14.

Dabei ist insbesondere vorgesehen, dass nach dem Ladevorgang ein Entladevorgang durchgeführt wird und während des Entladevorgangs eine Temperaturmessung und eine Anpassung eines Entladestromwerts während des Entladens durchgeführt wird.

Dabei kann insbesondere der Ladestromwert kontinuierlich während des Ladevorgangs angepasst werden. Ferner kann insbesondere während des Anpassens des Ladestromwerts der Ladevorgang unterbrochen werden. Hierzu kann insbesondere vorgesehen sein, dass zum Unterbrechen eine Schalteinrichtung 30 des Zyklisierers 16 zur Batteriezelle 12 geöffnet wird. Die Schalteinrichtung 30 kann insbesondere als Halbleiterelement bereitgestellt werden. Vorliegend ist insbesondere eine zweite Schalteinrichtung 32 gezeigt, welche insbesondere ein Zuschalten der elektronischen Recheneinrichtung 14, insbesondere eines Kalibriergeräts 38, ermöglicht.

Weiterhin kann vorgesehen sein, dass auf Basis einer zugeführen Ladungsmenge während des Ladevorgangs und auf Basis einer entnommenen Ladungsmenge während eines Entladevorgangs der Batteriezelle 12 mittels des Zyklisierers 16 die charakterisierende Eigenschaft bestimmt wird. Hierbei sind insbesondere mehrere Zyklen von Laden und Entladen vorgesehen. Als charakterisierende Eigenschaft kann dabei insbesondere eine Lebensdauer der Batteriezelle 12 und/oder eine Selbstentladungsdauer der Batteriezelle 12 bestimmt werden.

Des Weiteren ist, wie bereits erwähnt, das Verfahren während eines Hochpräzisionscoulometrie-Verfahrens durchgeführt.

Ebenfalls kann vorgesehen sein, dass zumindest nach dem Ladevorgang eine weitere Temperaturmessung durchgeführt wird. Des Weiteren kann vorgesehen sein, dass bei einem Überschreiten von zumindest einem Temperaturschwellwert eine Anpassung des Ladestromwerts durchgeführt wird. Ebenfalls kann vorgesehen sein, dass zum Anpassen des Ladestromwerts ein Korrekturfaktor in Abhängigkeit von dem Soll-Stromwert und der Temperatur ermittelt wird.

Insbesondere zeigt somit die Fig. 2, dass anstatt komplexe und teure Elemente, wie im Stand der Technik, innerhalb des Zyklisierers 16 zu integrieren, um den Abfluss von Wärme zu verbessern oder die Temperatur zu regulieren, akzeptiert das hier vorgestellte Verfahren, dass die Temperaturen im zeitlichen Verlauf nicht konstant sind. Um die Schwankungen durch die Temperatur auszugleichen, wird in einem erweiterten Schaltkreis, insbesondere gebildet durch die Temperaturerfassungseinrichtung 18 und die elektronische Recheneinrichtung 14 und dem Kalibriergerät 38, zwischengeschaltet, damit in regelmäßigen Abständen schnell und effizient ein Korrekturfaktor ermittelt werden kann, mit dessen Hilfe eine exakte Strommessung durchgeführt wird.

Dieser erweiterte Schaltkreis enthält insbesondere einen Temperatursensor 34, der die Temperatur der elektronischen Komponenten misst. Der Temperatursensor 34 kann ein Thermoelement, ein Thermistor oder eine andere Art von temperaturempfindlichem Gerät sein. Ferner kann auch ein Mikrocontroller 36 vorgesehen sein, der die Daten des Temperatursensors 34 verarbeitet und bestimmt, wann eine erneute Kalibrierung durchzuführen ist. Bei der elektronischen Recheneinrichtung 14 beziehungsweise auch dem Mikrocontroller 36 kann es sich auch um ein anderes elektronisches Gerät handeln, das für die Ausführung von Temperatursteuerungsfunktionen programmiert ist. Alternativ können die entsprechenden Steuerungen für den Temperatursensor 34 auch direkt über die elektronische Recheneinrichtung 14 realisiert werden.

Weicht die Temperatur nun von einem vorprogrammierten Wert ab, insbesondere einem Temperaturschwellwert, stoppt die elektronische Recheneinrichtung 14 die HPC-Messung an einem der definierten Arbeitspunkte (SoC). Währenddessen schaltet der Mikrcontroller 36 beziehungsweise die elektronische Recheneinrichtung 14 auf das Kalibriergerät 38, und die Messung der Stromstärke wird erneut eingestellt unter Berücksichtigung der aktuellen Umgebungsbedingungen inklusive Temperatur der Bauteile. Die jeweils gemessenen Stromwerte während der Kalibration innerhalb des Zyklisierers 16 sowie im externen Kalibriergerät 38 werden miteinander ab- beziehungsweise ausgeglichen.

### Bezugszeichenliste / List of Reference

- 10: Messvorrichtung
- 12: Batteriezelle
- 14: elektronische Recheneinrichtung
- 16: Zyklisierer
- 18: Temperaturerfassungseinrichtung
- 20: Signalgenerator
- 22: Signalkonvertierter
- 24: Stromverstärker
- 26: Widerstand
- 28: Feedbackverstärker
- 30: Schalteinrichtung
- 32: weitere Schalteinrichtung
- 34: Temperatursensor
- 36: Mikrocontroller
- 38: Kalibriergerät
- 40: Kontrollverstärker

## Patentansprüche

1. Verfahren zum Bestimmen einer eine Batteriezelle (12) charakterisierenden Eigenschaft mittels einer Messvorrichtung (10), mit den Schritten:
- Bereitstellen eines Soll-Stromwertes für einen Ladevorgang der Batteriezelle (12) mittels einer elektronischen Recheneinrichtung (14) der Messvorrichtung (10);
- Einstellen eines Ladestromwertes zum Laden der Batteriezelle (12) an einem Zyklisierer (16) der Messvorrichtung (10) in Abhängigkeit von dem Soll-Stromwert mittels des Zyklisierers (16);
- Bestimmen einer Temperatur des Zyklisierers (16) während des Ladevorgangs mittels einer Temperaturerfassungseinrichtung (18) der Messvorrichtung (10);
- Anpassen des Ladestromwertes während des Ladevorgangs in Abhängigkeit von der bestimmten Temperatur zum Erreichen des Soll-Stromwertes mittels des Zyklisierers(16);
- Laden der Batteriezelle (12) mittels des angepassten Ladestromwertes mittels des Zyklisierers (16); und
- Bestimmen der die Batteriezelle (12) charakterisierenden Eigenschaft auf Basis des durchgeführten Ladevorgangs mittels der elektronischen Recheneinrichtung (14).

2. Verfahren nach Anspruch 1, **dadurch gekennzeichnet, dass**
nach dem Ladevorgang ein Entladevorgang durchgeführt wird und bei dem Entladevorgang eine Temperaturmessung und eine Anpassung eines Entladestromwertes während des Entladens durchgeführt wird.

3. Verfahren nach Anspruch 1 oder 2, **dadurch gekennzeichnet, dass**
der Ladestromwert kontinuierlich während des Ladevorgangs angepasst wird.

4. Verfahren nach einem der vorhergehenden Ansprüche, **dadurch gekennzeichnet, dass** während des Anpassens des Ladestromwertes der Ladevorgang unterbrochen wird.

5. Verfahren nach Anspruch 4, **dadurch gekennzeichnet, dass**
zum Unterbrechen eine Schalteinrichtung (30) des Zyklisierers (16) zur Batteriezelle (12) geöffnet wird.

6. Verfahren nach Anspruch 5, **dadurch gekennzeichnet, dass**
die Schalteinrichtung (30) als Halbleiterelement bereitgestellt wird.

7. Verfahren nach einem der vorhergehenden Ansprüche, **dadurch gekennzeichnet, dass** auf Basis einer zugeführten Ladungsmenge während des Ladevorgangs und auf Basis einer entnommenen Ladungsmenge während eines Entladevorgangs der Batteriezelle (12) mittels des Zyklisierers (16) die charakterisierende Eigenschaft bestimmt wird.

8. Verfahren nach einem der vorhergehenden Ansprüche, **dadurch gekennzeichnet, dass** als charakterisierende Eigenschaft eine Lebensdauer der Batteriezelle (12) und/oder eine Selbstentladungsrate der Batteriezelle (12) bestimmt wird.

9. Verfahren nach einem der vorhergehenden Ansprüche, **dadurch gekennzeichnet, dass** das Verfahren während eines Hochpräzisionscoulometrie-Verfahrens durchgeführt wird.

10. Verfahren nach einem der vorhergehenden Ansprüche, **dadurch gekennzeichnet, dass** zumindest nach dem Ladevorgang eine weitere Temperaturmessung durchgeführt wird.

11. Verfahren nach einem der vorhergehenden Ansprüche, **dadurch gekennzeichnet, dass** bei einem Überschreiten von zumindest einem Temperaturschwellwert eine Anpassung des Ladestromwerts durchgeführt wird.

12. Verfahren nach einem der vorhergehenden Ansprüche, **dadurch gekennzeichnet, dass** zum Anpassen des Ladestromwerts ein Korrekturfaktor in Abhängigkeit von dem Soll-Stromwert und der Temperatur ermittelt wird.

13. Computerprogrammprodukt mit Programmcodemitteln, welche eine elektronische Recheneinrichtung (14) dazu veranlassen, wenn die Programmcodemittel von der elektronischen Recheneinrichtung (14) abgearbeitet werden, ein Verfahren nach einem der Ansprüche 1 bis 12 durchzuführen.

14. Computerlesbares Speichermedium mit einem Computerprogrammprodukt nach Anspruch 13.

15. Messvorrichtung (10) zum Bestimmen einer eine Batteriezelle (12) charakterisierenden Eigenschaft, mit zumindest einem Zyklisierer (16), einer elektronischen Recheneinrichtung (14) und einer Temperaturerfassungseinrichtung (18), wobei die Messvorrichtung (10) zum Durchführen eines Verfahrens nach einem der Ansprüche 1 bis 12 ausgebildet ist.
